# FASCICULE DE BREVET EUROPEEN

(11) **EP 1 890 958 B1**
(45) Date de publication et mention de la délivrance du brevet: **01.04.2009**
(21) Numéro de dépôt: 06709056.3
(22) Date de dépôt: 10.01.2006
(51) Int. Cl.: B81C 1/00, B81B 3/00

(54) **COMPOSANT MICROMÉCANIQUE AVEC DES ÉLÉMENTS ACTIFS, ET PROCÉDÉ DE RÉALISATION D'UN TEL COMPOSANT**
MIKROMECHANISCHE KOMPONENTE MIT AKTIVEN ELEMENTEN UND VERFAHREN ZUR HERSTELLUNG EINER KOMPONENTE DIESER ART
MICROMECHANICAL COMPONENT WITH ACTIVE ELEMENTS AND METHOD FOR PRODUCING A COMPONENT OF THIS TYPE

(30) Priorité: 11.01.2005 FR 0500274
(43) Date de publication de la demande: 27.02.2008
(73) Titulaire: COMMISSARIAT A L'ENERGIE ATOMIQUE, 75015 Paris (FR)
(72) Inventeur: JOISTEN, Hélène, F-38000 Grenoble (FR); CUCHET, Robert, F-38930 Monestier de Percy (FR); AUDOIN, Marcel, F-38360 Noyarey (FR); BARROIS, Gérard, F-38120 Le Fontanil (FR)
(74) Mandataire: Bonnans, Arnaud
(86) Numéro de dépôt international: PCT/FR2006/000045
(87) Numéro de publication internationale: WO 2006/075081

(56) Documents cités:
- US-A- 5 446 307
- US-A- 5 629 918
- US-A1- 2003 082 917
- US-B1- 6 251 698
- KIM P L ET AL: "Narrow-range angle sensor based on wiggles in angular dependence of pseudo-Hall effect" SENSORS AND ACTUATORS A, ELSEVIER SEQUOIA S.A., LAUSANNE, CH, vol. 97-98, 1 avril 2002 (2002-04-01), pages 308-317, XP004361617 ISSN: 0924-4247
- HUIKAI XIE ET AL: "A CMOS-MEMS MICROMIRROR WITH LARGE OUT-OF-PLANE ACTUATION" MICRO-ELECTRO-MECHANICAL SYSTEMS (MEMS). ASME INTERNATIONAL MECHANICAL ENGINEERING CONGRESS AND EXPOSITION, vol. 3, 11 novembre 2001 (2001-11-11), XP009016164
- KAWAHITO S ET AL: "A 2-D CMOS MICROFLUXGATE SENSOR SYSTEM FOR DIGITAL DETECTION OF WEAK MAGNETIC FIELDS" IEEE JOURNAL OF SOLID-STATE CIRCUITS, IEEE SERVICE CENTER, PISCATAWAY, NJ, US, vol. 34, no. 12, décembre 1999 (1999-12), pages 1843-1851, XP000932514 ISSN: 0018-9200

## Description

L'invention concerne un composant, notamment avec des éléments actifs, et un procédé de réalisation d'un tel composant. Il peut s'agir en particulier d'un composant microélectronique.

On utilise fréquemment des composants ayant pour partie au moins une structure en forme de plaque et dont une face porte des éléments actifs.

Dans le cadre de la microélectronique par exemple, un substrat peut porter des circuits électroniques tels que des capteurs de champ magnétique.

On souhaite parfois disposer les éléments actifs dans un plan incliné, voire perpendiculaire, par rapport au plan défini par la plaque.

C'est notamment le cas lorsque l'on désire obtenir la mesure d'un champ magnétique dans les trois dimensions comme décrit par exemple dans le brevet US 5 446 307.

Selon ce document, des capteurs magnétiques sont placés de manière à mesurer chacun la composante du champ magnétique perpendiculaire à l'une des faces inclinées d'une structure pyramidale, ce qui permet d'avoir accès de manière simple aux trois composantes du champ magnétique.

La technologie de gravure en face avant utilisée pour obtenir la structure pyramidale limite toutefois la hauteur envisageable pour cette structure à quelques micromètres et rend cette solution inapplicable à des capteurs magnétiques de plus grandes dimensions (par exemple de l'ordre de 1000 µm) dont l'utilisation sur les faces inclinées de la structure conduirait à une inclinaison bien trop faible de celles-ci (moins de 1 % d'inclinaison) pour pouvoir mesurer efficacement le champ magnétique dans une direction autre que perpendiculaire au substrat.

L'article "Narrow-range angle sensor based on wiggles in angular dependence of pseudo-Hall effect", de Phan Le Kim et al. in Sensors and actuators A97-98 (2002), pages 308-317, propose quant à lui le dépôt d'un capteur sur un wafer ainsi que la séparation de la partie du wafer portant le capteur par gravure, au cours de laquelle est également formée une charnière autour de laquelle la partie portant le capteur peut pivoter de quelques degrés.

Le brevet US 5 629 918 propose enfin une solution utilisable notamment pour la réalisation d'une antenne orientable, selon laquelle un volet obtenu par gravure plasma d'un wafer est articulé par rapport au wafer au moyen de poutres en forme de serpentin.

L'invention vise donc notamment à proposer une solution alternative pour obtenir, à partir d'une structure en forme de plaque, un plan incliné par rapport au reste de cette structure selon la revendication 12. Avantageusement, ce plan incliné pourra comprendre, avant ou après inclinaison, un capteur magnétique dans le cadre de la microélectronique ou tout autre dispositif microélectronique.

Ainsi, l'invention propose un procédé de réalisation d'un composant selon la revendication 1.

On peut ainsi obtenir une surface inclinée en utilisant une gravure relativement simple à mettre en oeuvre. L'inclinaison de la zone d'épaisseur réduite permet en outre à l'élément actif de travailler selon une autre direction (définie par l'inclinaison) que celle permise par la structure en forme de plaque, différente par exemple de celle-ci d'un angle compris entre 10 et 90 degrés.

L'élément actif est par exemple présent sur la première face avant inclinaison de la future zone d'épaisseur réduite. En variante, on peut venir, après l'étape d'inclinaison, reporter par collage par exemple un élément actif au niveau de la zone inclinée.

L'étape d'inclinaison peut être précédée d'une étape de formation d'une charnière sur une première partie de la circonférence de la zone d'épaisseur réduite et/ou d'une étape de gravure d'un chemin de découpe sur une seconde partie de la circonférence de la zone d'épaisseur réduite.

Ces étapes permettent notamment de délimiter précisément la zone à incliner.

L'étape de formation d'une charnière est par exemple réalisée par report, au moyen de l'étape de gravure de la seconde face, d'une encoche formée sur la seconde face. Cette solution particulière est particulièrement adaptée à l'invention.

Dans l'exemple décrit en détail dans la suite, l'élément actif est un capteur de champ magnétique, par exemple du type microfluxgate. Lorsqu'il est présent sur la face inclinée réalisée selon l'invention, un tel capteur peut mesurer une composante du champ magnétique orthogonale à la plaque.

Avantageusement, cet élément actif aura été réalisé sur la structure en forme de plaque "*plane*" selon les techniques standards de la microélectronique (gravure, dépôt, etc.) avant inclinaison.

Le ou les élément(s) actif(s) est (sont) disposé(s), avant ou après inclinaison, par exemple pour partie sur la zone d'épaisseur réduite et pour partie sur une partie de la structure non soumise à la gravure de la seconde face.

On obtient ainsi des éléments actifs dirigés selon des directions qui permettent d'avoir accès à une grandeur selon les trois dimensions de l'espace

Selon une possibilité de mise en oeuvre, le procédé comprend une étape de report de la structure sur un substrat qui peut être réalisée avant ou après l'étape d'inclinaison.

La seconde face de la structure peut alors être placée au contact du substrat et une extrémité de la zone d'épaisseur réduite peut venir au contact du substrat après l'étape d'inclinaison, afin de définir une nouvelle position stable pour cette zone.

L'invention propose également un composant comprenant une zone inclinée par rapport à une structure en forme de plaque, caractérisé en ce que la zone inclinée possède une épaisseur réduite par rapport à ladite structure et en ce que le composant présente un évidement entre la zone inclinée et ladite structure. Un élément actif est disposé sur une première face de la zone inclinée.

La zone inclinée est reliée à la structure en forme de plaque par une charnière, qui comprend par exemple une partie d'épaisseur inférieure à l'épaisseur de la zone inclinée.

Des caractéristiques et avantages du procédé exposés ci-dessus s'appliquent également par analogie au composant qui vient d'être mentionné.

Notamment, la seconde face de la structure en forme de plaque peut être solidaire d'un substrat. L'extrémité de la zone inclinée opposée à la structure en forme de plaque est située alors située par exemple au contact du substrat.

On peut également prévoir dans ce cas des moyens de maintien de la zone inclinée par rapport au substrat. Ces moyens de maintien comprennent par exemple une colle ou résine qui englobe la zone de contact du substrat et de la zone inclinée, et/ou mettent en oeuvre des forces électrostatiques ou magnétiques.

Lorsque l'élément actif est un capteur de champ magnétique, celui-ci peut ainsi mesurer un champ selon une direction parallèle à la zone inclinée et formant un angle non nul avec la structure en forme de plaque. Ce capteur permet d'avoir accès à la composante du champ magnétique orthogonale à la structure en forme de plaque.

D'autres caractéristiques et avantages de l'invention apparaîtront mieux à la lumière de la description qui suit, faites en référence aux dessins annexés, dans lesquels :
- les figures 1 à 3 représentent un procédé de réalisation d'un composant selon un premier mode de réalisation de l'invention ;
- la figure 4 représente schématiquement les éléments essentiels du composant au cours de sa réalisation en vue de dessus.

Au début de son procédé de réalisation, le composant comprend essentiellement une plaque d'épaisseur essentiellement constante (par exemple de l'ordre de 500 µm d'épaisseur), réalisée par exemple en silicium, et une couche d'isolant 4, 5 dans laquelle sont encapsulés des éléments actifs, ici des circuits électroniques, et notamment des capteurs de champ magnétiques 6, 8, 10, 12 tels que ceux utilisés en microélectronique, généralement dénommés "*microfluxgate*"*.*

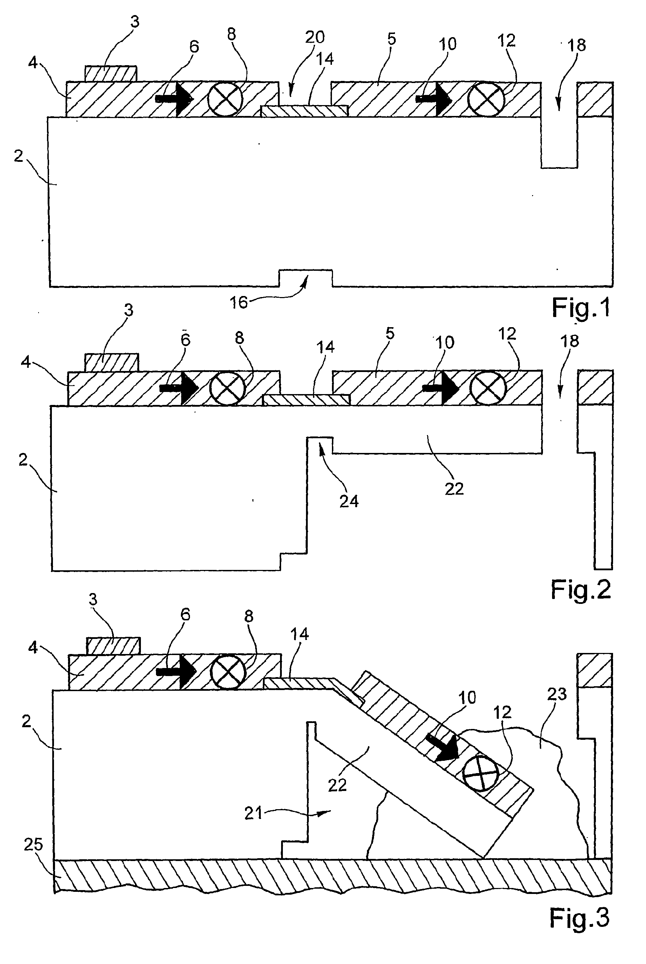

Les capteurs sont répartis en deux groupes : des premiers capteurs 6, 8 dans une première partie 4 de la couche d'isolant (partie située à gauche en figure 1) et des seconds capteurs 10, 12 dans une seconde partie 5 de la couche d'isolant (partie située à droite de la figure 1).

Dans chaque groupe, les deux capteurs sont disposés de manière à mesurer des composantes *X*, *Y* orthogonales entre elles du champ magnétique.

Pour d'autres applications, il pourra y avoir seulement un capteur pour l'un ou les deux groupes, voire un seul groupe d'un ou d'une pluralité de capteurs destinés à être inclinés.

A cette étape du procédé, tous les capteurs sont donc placés de telle sorte que leur direction de mesure est une composante horizontale du champ magnétique (c'est-à-dire parallèle à la plaque 2, dans le plan formé par les directions *X* et *Y*). Ils ont par exemple été fabriqués à partir de la plaque de silicium 2 selon les techniques standards de la microélectronique, par exemple de façon collective.

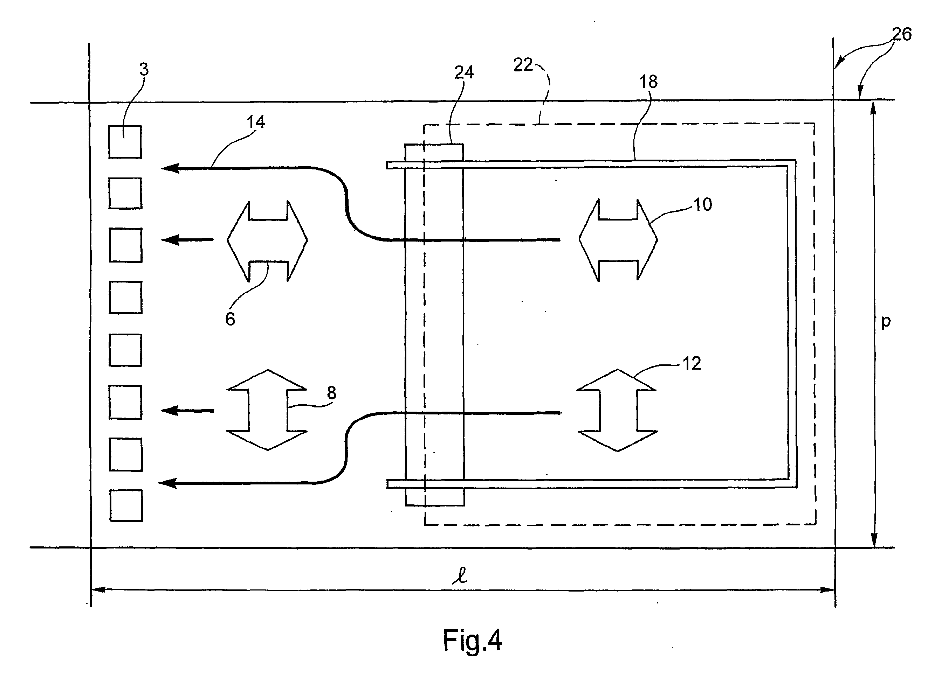

Des plots de connexion sont déposés sur la face supérieure de la couche d'isolant 4, 5 (face opposée à la plaque de silicium 2). Ces plots 3 sont connectés aux différents capteurs 6, 8, 10, 12 comme schématiquement représenté aux figures 4 et 5 et décrit en détail plus bas.

Dans une étape facultative de préparation des faces du composant, on peut procéder à l'élimination de la couche d'isolant 4, 5 (par exemple SiO₂ ou un polymère par exemple de type BCB) sur une partie de largeur réduite 20 (par exemple de l'ordre de 100 µm) située entre les premiers capteurs 6, 8 et les seconds capteurs 10, 12, tout en préservant l'intégrité dans cette partie de largeur réduite 20 des pistes 14 de connexion des capteurs 10, 12 aux plots correspondant 3. Ces pistes 14 (dont une partie seulement est schématiquement représentée sur les figures) sont par exemple réalisées en cuivre.

Cette étape d'élimination de la couche d'isolant n'est pas nécessaire si cet isolant est suffisamment flexible sur cette partie de largeur réduite, du fait du matériau choisi et/ou de son épaisseur, pour s'intégrer dans la charnière à venir.

On ménage par ailleurs une encoche 16 (par exemple également par gravure) dans la face inférieure de la plaque 2 (c'est-à-dire dans la face opposée à la face supérieure portant la couche 4 en matériau isolant). L'encoche 16 est également réalisée sur une partie de largeur réduite située au droit de la partie de largeur réduite 20 où la couche d'isolant 4 a été éliminée. L'encoche s'étend par exemple avec une profondeur de l'ordre de 100 µm dans l'épaisseur de la plaque 2.

On grave également un chemin de découpe 18 qui traverse la couche d'isolant 5 et attaque sur une partie relativement faible (mais non négligeable) de son épaisseur la plaque 2, par exemple sur une profondeur de 150 µm. Le chemin de découpe 18 s'étend sur une partie substantielle de la circonférence de la seconde partie 5 de la couche d'isolant telle que définie plus haut.

On obtient alors pour le composant en cours de réalisation la structure représentée à la figure 1.

On peut d'ailleurs remarquer que la couche réalisée en matériau isolant 4, 5 est alors physiquement divisée en deux parties de couche dont l'une (première partie, référencée 4) comprend les premiers capteurs 6, 8 et dont l'autre (seconde partie, référencée 5) comprend les seconds capteurs 10, 12.

La seconde partie 5 de la couche en matériau isolant est ainsi délimitée d'une part par la partie éliminée de largeur réduite 20, et d'autre part par la cavité 18.

On procède alors à la gravure d'une région de la face inférieure de la plaque 2 (ou face arrière) qui s'étend latéralement de la partie d'isolant éliminée de largeur réduite 20 à la cavité 18, ce qui correspond par exemple à une largeur de l'ordre de 1mm (soit 1000 µm). Cette gravure est effectuée sur une partie substantielle de l'épaisseur de la plaque 2 de manière à ne laisser subsister dans la région précédemment définie qu'une épaisseur réduite de la plaque 2, comme montré sous la référence 22 à la figure 2.

Une telle épaisseur réduite a par exemple une valeur de l'ordre de 150 µm.

De manière générale, la profondeur de gravure doit être suffisante pour permettre l'inclinaison de la région d'épaisseur réduite 22 (dans l'espace laissé libre par la gravure) comme décrit plus loin, tout en maintenant une rigidité suffisante de cette région pour porter les capteurs (sauf au niveau de la charnière mentionnée ci-après).

La gravure utilisée est par exemple une gravure anisotrope qui permet d'attaquer précisément la région précédemment définie, par exemple une gravure de type RIE (gravure ionique réactive).

Par ailleurs, on choisit de préférence une gravure qui élimine une profondeur uniforme (ici 350 µm) du matériau de la plaque 2, ce qui permet de reporter l'encoche 16 ménagée dans la face inférieure initiale de la plaque 2 dans la région d'épaisseur réduite 22 pour réaliser ainsi une charnière 24, dont l'épaisseur dans l'exemple présenté est ainsi limité à 50 µm.

En outre, la profondeur de gravure est telle que l'épaisseur de la plaque est réduite à néant au niveau du chemin de découpe 18, ce qui permet de séparer les deux parties de plaque de part et d'autre du chemin de découpe 18.

La structure ainsi obtenue est représentée à la figure 2.

La région d'épaisseur réduite 22 est ainsi séparée du reste de la plaque 2 par le chemin de découpe 18 sur une partie substantielle de sa circonférence (ici les trois côtés d'un rectangle) et liée au reste de la plaque 2 par la charnière 24 sur la partie résiduelle de sa circonférence (ici le quatrième côté du rectangle).

En variante, il est possible de réaliser la gravure profonde en face arrière avant tout ou partie de la gravure du chemin de découpe 18.

Il est possible également qu'il subsiste après gravure en face arrière une faible épaisseur de matériau au niveau du chemin de découpe, épaisseur qui pourra être rompue ultérieurement, par exemple par une action mécanique ou une nouvelle gravure du chemin de découpe, au moment voulu pour l'inclinaison, ou encore par une sollicitation magnétique ou électrostatique.

La structure peut alors être reportée sur un substrat 25, par exemple une seconde plaque de silicium avec interposition d'une colle 23 (ou de tout autre matériau comme une résine par exemple, qui peut être déposée collectivement par des moyens standard de la microélectronique) pour remplissage au moins partiel de la partie laissée libre par la gravure de la face arrière de la plaque 2. Cette colle permettra d'assurer le maintien de la partie d'épaisseur réduite dans une position inclinée sans possibilité de mouvement ultérieur. D'autres moyens peuvent être prévus pour assurer ce maintien, dans la mesure où ils ne perturbent pas le fonctionnement des capteurs ou autres composants présents sur le dispositif. On peut ainsi envisager pour certaines applications un maintien par le biais de forces électrostatiques et/ou magnétiques par exemple.

Grâce à la charnière 24 réalisée comme mentionné précédemment, on obtient facilement une inclinaison de la partie d'épaisseur réduite 22 (qui porte la seconde partie 5 de la couche de matériau isolant et les seconds capteurs 10, 12). Cette inclinaison peut être provoquée par une sollicitation mécanique et/ou électrostatique et/ou magnétique, ou intervenir automatiquement au moment de la gravure en face arrière ou du chemin de découpe 18. Elle peut intervenir avant ou après l'étape de report.

On obtient ainsi pour le composant une structure qui, comme représenté à la figure 3, comprend dans une première partie la plaque 2 avec son épaisseur initiale et les premiers capteurs 6, 8 en face supérieure, et dans une deuxième partie la région d'épaisseur réduite 22 dont la face supérieure, qui porte les seconds capteurs 10, 12, est inclinée par rapport à la face supérieure de la première partie de la plaque 2.

Dans l'exemple décrit ici, on obtient une inclinaison de l'ordre de 20°, mais d'autres valeurs de dimensions pourraient naturellement être utilisées pour obtenir d'autres valeurs d'inclinaison (de manière générale entre 10° et 90°), fonction des propriétés mécaniques du (ou des) matériau(x) au niveau de la charnière (dimensions, flexibilité, *etc.*). Une inclinaison de 90° peut ainsi être atteinte avec une charnière adaptée.

Le procédé utilisé laisse subsister un évidement 21 entre la première partie de la plaque 2 d'épaisseur initiale et la partie d'épaisseur réduite 22 inclinée.

Le second capteur 10 qui était initialement situé dans un plan horizontal (c'est-à-dire essentiellement parallèle à la face supérieure de la plaque 2) est donc à présent incliné par rapport à l'horizontale et ne mesure donc plus seulement une composante selon la direction *X*, mais une combinaison des composantes selon les directions *X* et *Z* du champ magnétique, d'où il est facile de déduire la composante selon la direction *Z* (*i.e.* perpendiculaire au plan de la plaque 2) puisque la composante selon la direction *X* est donnée par le premier capteur horizontal 6.

On remarque par ailleurs que l'utilisation d'un matériau relativement souple pour la formation des pistes électriques (comme par exemple le cuivre) permet d'éviter les risques de rupture de ces pistes lors de l'inclinaison de la partie d'épaisseur réduite 22 par rapport à la plaque 2.

L'inclinaison de la face supérieure de la partie d'épaisseur réduite 22 par rapport à la plaque 2 a ainsi été obtenue par des techniques relativement simples mettant en oeuvre des gravures avec une profondeur constante pour des régions déterminées. Cette solution est donc particulièrement intéressante pour des domaines dans lesquels la définition des structures doit se limiter à des opérations simples, comme la microélectronique (exemple décrit ici), la micromécanique ou l'optique intégrée.

Dans l'exemple qui vient d'être décrit, les capteurs 8, 12 sont tous les deux aptes à mesurer la composante du champ magnétique selon la direction *Y*. En variante, on aurait donc pu utiliser un seul de ces deux capteurs 8, 12 et l'un des groupes de capteurs définis plus haut aurait donc pu se limiter à un seul capteur.

La figure 4 représente schématiquement le composant au cours de son procédé de réalisation, précisément à l'étape représentée à la figure 2.

Le composant a une forme rectangulaire et s'étend selon la direction *X* avec une dimension *l* de l'ordre de 2,5 mm (qui correspond à la largeur de l'ensemble de la plaque 2, y compris la partie d'épaisseur réduite 22, sur les figures 1 à 3) et selon la direction *Y* avec une dimension *p* de l'ordre de 1,5 mm.

On peut remarquer qu'un seul composant a été représenté sur la figure 4, mais que plusieurs composants peuvent être réalisés au cours du même procédé à l'échelle du substrat, puis découpés selon les lignes de découpe 26 présentées en figure 4.

On a schématiquement représenté en figure 4 les premiers capteurs 6, 8 disposés dans la première partie 4 de la couche d'isolant, c'est-à-dire au droit de la plaque 2 dans sa partie où l'épaisseur initiale est conservée ; les seconds capteurs 10, 12 sont également schématiquement représentés au niveau de la seconde partie 5 de la couche d'isolant située au droit de la partie 22 de plaque dont l'épaisseur a été réduite par la gravure en face arrière.

On a également schématiquement représenté les pistes 14 destinées à relier chacun des capteurs 6, 8, 10, 12 à deux plots électriques 3 afin d'établir une connexion électrique entre chacun des capteurs 6, 8, 10, 12 et un circuit électronique de mesure (non représenté).

La figure 4 illustre également la région d'épaisseur réduite 22 au niveau de laquelle la plaque 2 a subi la gravure en face arrière comme expliqué en référence aux figures 1 et 2.

Enfin, la figure 4 présente le chemin de découpe 18 réalisé essentiellement sur les trois côtés d'un rectangle et la charnière 24 réalisée en face arrière dans la plaque 2 qui termine la définition de la région de forme rectangulaire destinée à être inclinée relativement aux autres parties de la plaque 2.

L'exemple qui vient d'être décrit ne représente qu'un mode possible de mise en oeuvre de l'invention.

En variante, on peut prévoir d'incliner une zone d'un substrat selon un procédé similaire à celui décrit précédemment, pour ensuite venir coller sur le plan incliné ainsi obtenu un ou plusieurs composants actifs.

Selon une autre variante, que l'on peut éventuellement combiner avec la précédente, la partie d'épaisseur réduite pourrait être inclinée dans un sens opposé à celui décrit ci-dessus (c'est-à-dire vers le haut à partir de la figure 2, et non vers le bas comme en figure 3). On pourrait prévoir dans ce cadre que l'étape de gravure libère des contraintes au sein de la plaque qui provoquent l'inclinaison souhaitée de la zone gravée.

## Revendications

1. Procédé de réalisation d'un composant comprenant une première face d'une structure en forme de plaque (2), **caractérisé en ce qu'**il comprend les étapes suivantes :
- gravure d'une seconde face de la structure, opposée à la première face, sur une partie de sa surface afin de définir une zone d'épaisseur réduite (22) ;
- formation d'une charnière (24) sur une première partie de la circonférence de la zone d'épaisseur réduite (22) ;
- inclinaison de la zone d'épaisseur réduite (22) dans une position inclinée sans possibilité de mouvement par rapport à ladite structure (2), le composant comportant au moins un élément actif (10, 12) au niveau de la zone inclinée (22).

2. Procédé de réalisation selon la revendication 1, dans lequel la première face porte l'élément actif (10, 12) avant l'étape d'inclinaison.

3. Procédé de réalisation selon la revendication 1, dans lequel l'élément actif (10, 12) est rapporté sur la zone inclinée (22) après l'étape d'inclinaison.

4. Procédé de réalisation selon la revendication 3, comprenant une étape de collage de l'élément actif (10, 12) rapporté.

5. Procédé de réalisation selon l'une des revendications 1 à 4, dans lequel l'étape d'inclinaison est précédée d'une étape de gravure d'un chemin de découpe (18) sur une seconde partie de la circonférence de la zone d'épaisseur réduite (22).

6. Procédé de réalisation selon l'une des revendications 1 à 5, dans lequel l'étape de formation d'une charnière est réalisée par report, au moyen de l'étape de gravure de la seconde face, d'une encoche (16) formée sur la seconde face.

7. Procédé de réalisation selon l'une des revendications 1 à 6, dans lequel l'élément actif (10, 12) est un capteur de champ magnétique.

8. Procédé de réalisation selon la revendication 7, dans lequel le capteur de champ magnétique est du type microfluxgate.

9. Procédé de réalisation selon l'une des revendications 1 à 8, dans lequel au moins un élément actif (6, 8) est disposé sur une partie de la structure non soumise à la gravure de la seconde face.

10. Procédé de réalisation selon l'une des revendications 1 à 9, comprenant une étape de report de la structure sur un substrat (25).

11. Procédé de réalisation selon la revendication 10, dans lequel la seconde face de la structure est au contact du substrat et dans lequel une extrémité de la zone d'épaisseur réduite vient au contact du substrat.

12. Composant comprenant une zone inclinée (22) sans possibilité de mouvement par rapport à une structure en forme de plaque (2) et au moins un élément actif (10, 12) disposé sur une première face de la zone inclinée (22),
**caractérisé en ce que** la zone inclinée possède une épaisseur réduite par rapport à ladite structure et est reliée à la structure (2) par une charnière (24) et **en ce que** le composant présente un évidement (21) entre la zone inclinée (22) et ladite structure (2).

13. Composant selon la revendication 12, dans lequel la charnière (24) comprend une partie d'épaisseur inférieure à l'épaisseur de la zone inclinée (22).

14. Composant selon la revendication 12 ou 13, dans lequel la structure en forme de plaque (2) comporte au moins un composant actif (6, 8) sur une première face.

15. Composant selon l'une des revendications 12 à 14, dans lequel la seconde face de la structure en forme de plaque (2) est solidaire d'un substrat (25).

16. Composant selon la revendication 15, dans lequel une extrémité de la zone inclinée (22) opposée à la structure en forme de plaque (2) est située au contact du substrat (25).

17. Composant selon la revendication 16, comprenant des moyens de maintien de la zone inclinée (22) par rapport au substrat (25).

18. Composant selon la revendication 17, dans lequel les moyens de maintien comprennent une colle ou résine qui englobe la zone de contact du substrat (25) et de la zone inclinée (22).

19. Composant selon la revendication 17 ou 18, dans lequel les moyens de maintien mettent en oeuvre des forces électrostatiques ou magnétiques.

20. Composant selon l'une des revendications 12 à 19, dans lequel l'élément actif (6, 8) est un capteur de champ magnétique.

21. Composant selon la revendication 20, dans lequel le capteur de champ magnétique est un microfluxgate.

22. Composant selon la revendication 20 ou 21, dans lequel le capteur (10) de champ magnétique est apte à mesurer un champ selon une direction parallèle à la zone inclinée et formant un angle non nul avec la structure en forme de plaque.

## Claims

1. Method of producing a component comprising a first face of a plate-shaped structure (2), **characterised in that** it comprises the following steps:
- etching a second face of the structure, opposite the first face, over a portion of its surface in order to define a reduced thickness area (22);
- forming a hinge (24) over a first portion of the circumference of the reduced area thickness (22);
- inclining the reduced thickness area (22) in an inclined position with no possibility of movement relative to said structure (2), the component including at least one active element (10, 12) in the inclined area (22).

2. Production method according to claim 1, wherein the first face carries the active element (10, 12) before the inclination step.

3. Production method according to claim 1, wherein the active element (10, 12) is attached to the inclined area (22) after the inclination step.

4. Production method according to claim 3, comprising a step of gluing the attached active element (10, 12).

5. Production method according to any one of claims 1 to 4, wherein the inclination step is preceded by a step of etching a cutting path (18) over a second portion of the circumference of the reduced thickness area (22).

6. Production method according to any one of claims 1 to 5, wherein the step of forming a hinge is carried out by transferring, by means of the step of etching the second face, a notch (16) formed on the second face.

7. Production method according to any one of claims 1 to 6, wherein the active element (10, 12) is a magnetic field sensor.

8. Production method according to claim 7, wherein the magnetic field sensor is of the microfluxgate type.

9. Production method according to any one of claims 1 to 8, wherein at least one active element (6, 8) is disposed on a portion of the structure not subjected to the etching of the second face.

10. Production method according to any one of claims 1 to 9, comprising a step of transferring the structure onto a substrate (25).

11. Production method according to claim 10, wherein the second face of the structure is in contact with the substrate and wherein one end of the reduced thickness area comes into contact with the substrate.

12. Component comprising an area (22) inclined with no possibility of movement relative to a plate-shaped structure (2) and at least one active element (10, 12) disposed on a first face of the inclined area (22),
**characterised in that** the inclined area has a reduced thickness relative to said structure and is connected to the structure (2) by a hinge (24) and **in that** the component has a recess (21) between the inclined area (22) and said structure (2).

13. Component according to claim 12, wherein the hinge (24) comprises a portion of thickness less than the thickness of the inclined area (22).

14. Component according to claim 12 or 13, wherein the plate-shaped structure (2) includes at least one active component (6, 8) on a first face.

15. Component according to any one of claims 12 to 14, wherein the second face of the plate-shaped structure (2) is fastened to a substrate (25).

16. Component according to claim 15, wherein an end of the inclined area (22) opposite the plate-shaped structure (2) is situated in contact with the substrate (25).

17. Component according to claim 16, comprising means for holding the inclined area (22) relative to the substrate (25).

18. Component according to claim 17, wherein the holding means comprises a glue or resin that encompasses the area of contact of the substrate (25) and the inclined area (22).

19. Component according to claim 17 or 18, wherein the holding means employ electrostatic or magnetic forces.

20. Component according to any one of claims 12 to 19, wherein the active element (6, 8) is a magnetic field sensor.

21. Component according to claim 20, wherein the magnetic field sensor is a microfluxgate.

22. Component according to claim 20 or 21, wherein the magnetic field sensor (10) is adapted to measure a field in a direction parallel to the inclined area and forming a non-zero angle with the plate-shaped structure.

## Patentansprüche

1. Verfahren zur Herstellung eines Bauelements, umfassend eine erste Seite einer plattenförmigen Struktur (2), **dadurch gekennzeichnet, dass** es die folgenden Schritte umfasst:
- Gravieren einer zweiten Seite der Struktur, die der ersten entgegengesetzt ist, auf einem Teil ihrer Fläche, um eine Zone (22) von verminderter Dicke zu bilden;
- Bildung eines Scharniers (24) auf einem ersten Teil des Umfangs der Zone (22) verminderter Dicke;
- Neigung der Zone (22) verminderter Dicke in eine geneigte Stellung ohne Bewegungsmöglichkeit bezüglich der Struktur (2), wobei das Bauelement mindestens ein aktives Element (10, 12) auf Höhe der geneigten Zone (22) umfasst.

2. Herstellungsverfahren nach Anspruch 1, bei dem die erste Seite das aktive Element (10, 12) vor dem Schritt der Neigung trägt.

3. Herstellungsverfahren nach Anspruch 1, bei dem das aktive Element (10, 12) auf der geneigte Zone (22) nach dem Schritt der Neigung angebracht wird.

4. Herstellungsverfahren nach Anspruch 3, umfassend einen Schritt der Verklebung des angebrachten aktiven Elements (10, 12).

5. Herstellungsverfahren nach einem der Ansprüche 1 bis 4, bei dem dem Schritt der Neigung ein Schritt des Gravierens eines Schnittwegs (18) auf einem zweiten Teil des Umfangs der Zone (22) verminderter Dicke vorhergeht.

6. Herstellungsverfahren nach einem der Ansprüche 1 bis 5, bei dem der Schritt der Bildung eines Scharniers durch Übertragung einer auf der zweiten Seite gebildeten Nut (16) mit Hilfe des Schritts des Gravierens der zweiten Seite vorgenommen wird.

7. Herstellungsverfahren nach einem der Ansprüche 1 bis 6, bei dem das aktive Element (10, 12) ein Magnetfeldsensor ist.

8. Herstellungsverfahren nach Anspruch 7, bei dem der Magnetfeldsensor vom Typ Microfluxgate ist.

9. Herstellungsverfahren nach einem der Ansprüche 1 bis 8, bei dem mindestens das aktive Element (6, 8) auf einem Teil der Struktur angeordnet ist, der nicht dem Gravieren der zweiten Seite ausgesetzt wird.

10. Herstellungsverfahren nach einem der Ansprüche 1 bis 9, umfassend einen Schritt der Übertragung der Struktur auf ein Substrat (25).

11. Herstellungsverfahren nach Anspruch 10, bei dem die zweite Seite der Struktur mit dem Substrat in Kontakt ist und bei dem ein Ende der Zone verminderter Dicke mit dem Substrat in Kontakt kommt.

12. Bauelement, umfassend eine geneigte Zone (22) ohne Bewegungsmöglichkeit bezüglich einer plattenförmigen Struktur (2) und mindestens ein aktives Element (10, 12), das auf einer ersten Seite der geneigten Zone (22) angeordnet ist,
**dadurch gekennzeichnet, dass** die geneigte Zone eine bezüglich der Struktur verminderte Dicke besitzt und mit der Struktur (2) durch ein Scharnier (24) verbunden ist und dass das Bauelement zwischen der geneigten Zone (22) und der Struktur (2) eine Ausnehmung (21) umfasst.

13. Bauelement nach Anspruch 12, bei dem das Scharnier (24) einen Teil umfasst, der eine kleinere Dicke als die geneigte Zone (22) aufweist.

14. Bauelement nach Anspruch 12 oder 13, bei dem die plattenförmige Struktur (2) mindestens ein aktives Bauelement (6, 8) auf einer ersten Seite aufweist.

15. Bauelement nach einem der Ansprüche 12 bis 14, bei dem die zweite Seite der plattenförmigen Struktur (2) mit einem Substrat (25) fest verbunden ist.

16. Bauelement nach Anspruch 15, bei dem ein Ende der geneigten Zone (22), das der plattenförmigen Struktur (2) entgegengesetzt ist, in Kontakt mit dem Substrat (25) gelegen ist.

17. Bauelement nach Anspruch 16, umfassend Mittel zum Halten der geneigten Zone (22) bezüglich des Substrats (25).

18. Bauelement nach Anspruch 17, bei dem die Haltemittel einen Klebstoff oder ein Harz umfassen, der bzw. das die Kontaktzone des Substrats (25) und der geneigten Zone (22) einschließt.

19. Bauelement nach Anspruch 17 oder 18, bei dem die Haltemittel elektrostatische oder magnetische Kräfte einsetzen.

20. Bauelement nach einem der Ansprüche 12 bis 19, bei dem das aktive Element (6, 8) ein Magnetfeldsensor ist.

21. Bauelement nach Anspruch 20, bei dem der Magnetfeldsensor ein Mikrofluxgate ist.

22. Bauelement nach Anspruch 20 oder 21, bei dem der Magnetfeldsensor (10) in der Lage ist, ein Feld in einer Richtung zu messen, die zur geneigten Zone parallel ist und mit der plattenförmigen Struktur einen Winkel von nicht Null bildet.
